(19) Europäisches Patentamt

European Patent Office

Office européen des brevets

(11) **EP 1 675 296 A2**

(12) **EUROPEAN PATENT APPLICATION**

(43) Date of publication:
**28.06.2006 Bulletin 2006/26**

(51) Int Cl.:
***H04L 1/06*** (2006.01)

(21) Application number: **05028499.1**

(22) Date of filing: **27.12.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **27.12.2004 KR 2004113360**

(71) Applicant: **Samsung Electronics Co., Ltd.**
**Suwon-si, Gyeonggi-Do (KR)**

(72) Inventors:
• **Li, Ying**
  **Shaanxi China 710071 (CN)**

• **Hui, Junhong**
  **Giheung-eup**
  **Yongin-si**
  **Gyeonggi-do (KR)**
• **Choi, Eoi-Young**
  **Yeongtong-gu**
  **Suwon-si**
  **Gyeonggi-do (KR)**
• **Wang, Xinmei**
  **Xi'an**
  **Shaanxi China 710071 (CN)**

(74) Representative: **Grünecker, Kinkeldey,**
**Stockmair & Schwanhäusser**
**Anwaltssozietät**
**Maximilianstrasse 58**
**80538 München (DE)**

(54) **Generalized recursive space-time trellis code encoder**

(57) Provided is a generalized Recursive STTC (Space-Time Trellis Code) encoder which can improve diversity gain and coding gain in terms of transmission without increasing circuit complexity in a transmission system by forming an internal encoder of a multi-antenna mobile telecommunication system using a Recursive Systematic Convolutional code (RSC) block having two output ends to form a systematic ineral encoder. In addition, the generalized RSTTC encoder has a ratio of input data to output data (n-1):n by using a plurality of parallel RSC blocks each having two output ends. Thus, flexibility can be given to the size of data input to each RSC block and a transmission data rate can be improved in the internal encoder of a transmission system.

FIG.2

EP 1 675 296 A2

## Description

The present invention generally relates to a multi-antenna mobile communication system, and in particular, to a multi-antenna mobile communication system using a Space-Time Trellis Code (STTC).

With the rapid development of mobile telecommunication systems, the amount of data serviced by the mobile telecommunication system has also increased. Recently, a third generation (3G) mobile telecommunication system for transmitting high-speed data has been developed. For the 3G generation mobile telecommunication system, Europe has adopted an asynchronous Wideband-Code Division Multiple Access (W-CDMA) system as its radio access standard, while North America has adopted a synchronous Code Division Multiple Access-2000 (CDMA-2000) system as its radio access standard. Generally, in these mobile telecommunication systems, a plurality of mobile stations (MSs) communicate with each other via a common base station (BS). However, during high-speed data transmission in the mobile telecommunication system, the phase of the received signal may be distorted due to a fading phenomenon occurring on a radio channel. The fading phenomenon reduces the amplitude of a received signal by several dB to several tens of dB. If the phase of the received signal distorted due to the fading phenomenon is not compensated for during data demodulation, the phase distortion becomes a cause of information error of the transmitted data (transmission data transmitted by transmission side), causing a reduction in the quality of a telecommunication service. Therefore, in order to transmit high-speed data without a decrease in the service quality, mobile telecommunication systems should use diversity techniques to overcome fading.

Generally, a CDMA system utilizes a rake receiver that performs diversity reception by exploiting delay spread of a channel. While it applies reception diversity for receiving a multi-path signal, a rake receiver applying the diversity technique by exploiting the delay spread is disadvantageous in that it does not operate when the delay spread is less than a preset value. In addition, time diversity technique with interleaving and coding is used in a Doppler spread channel. However, time diversity technique is disadvantageous in that it can hardly be used in a low-speed Doppler spread channel.

Therefore, in order to cope with fading, space diversity technique is used in the channel with low delay spread, such as an indoor channel, or the channel with low-speed Doppler spread, such as a pedestrian channel. Space diversity technique uses two or more transmission/reception antennas. In this technique, when a signal transmitted via one transmission antenna decreases in its signal power due to fading, a signal transmitted via the other transmission antenna is received. The space diversity technique can be classified into reception antenna diversity technique using reception antennas and transmission diversity technique using transmission antennas. However, because the reception antenna diversity technique is applied to a mobile station, it is difficult to install a plurality of antennas in the mobile station in view of the mobile station's size and its installation cost. Therefore, it is recommended that diversity technique should be used at the transmission side where a plurality of transmission antennas are installed in a base station.

Particularly, in the fourth generation (4G) mobile communication system, a data rate of about 10Mbps to 150Mbps is expected, and a bit error rate (BER) of $10^{-3}$ for voice, a BER of $10^{-6}$ for data, and a BER of $10^{-9}$ for images are required.

The STTC is a combination of a multi-antenna technique and a channel coding technique, and is a technique bringing a drastic improvement of data rate and reliability in a radio Multi Input Multi Output (MIMO) channel. The STTC acquires space-time diversity gain by extending the space-time dimension of a transmitter's transmission signal. In addition, STTC can acquire a coding gain without a supplemental bandwidth, contributing to an improvement in channel capacity. Therefore, in the transmission diversity technique, STTC is used. When STTC is used, a coding gain having an effect of increasing transmission power is acquired together with a diversity gain which is equivalent to a reduction in channel attenuation occurring due to a fading channel when the multiple transmission antennas are used.

A method for transmitting a signal using the STTC is disclosed by Vahid Tarokh, N. Seshadri, and A. Calderbank, in "Space Time Codes For High Data Rate Wireless Communication: Performance Criterion And Code Construction," IEEE Trans. on Info. Theory, pp. 744-765, Vol. 44, No. 2, March 1998.

Since a Recursive STTC (RSTTC) suggested by Gulati and Narayanan provides a superior interleaving gain, it may serve as a superior internal code and be used for concatenation system. The RSTTC is composed of a plurality of parallel recursive convolutional codes.

To serially connect the RSTTC and other channel codes, both a diversity gain and an interleaving gain can be acquired using a typical channel code such as RS (Reed-Solomon) code or convolutional code as an external code and the RSTTC as an internal code.

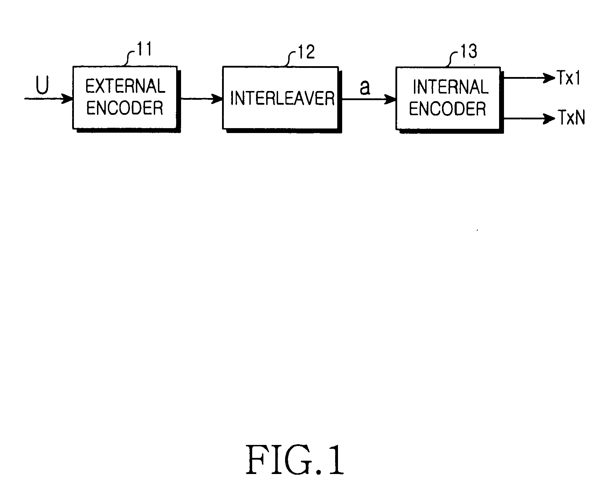

Fig. 1 is a schematic block diagram of a general transmission system.

Referring to Fig. 1, the general transmission system includes an external encoder 11 for receiving a data bit U to be transmitted and performing external encoding of channel coding or convolution coding, an interleaver 12 for interleaving data encoded by the external encoder 11, and an internal encoder 13 for receiving a data bit a interleaved by the interleaver 12 and performing internal encoding for transmission using an RSTTC scheme.

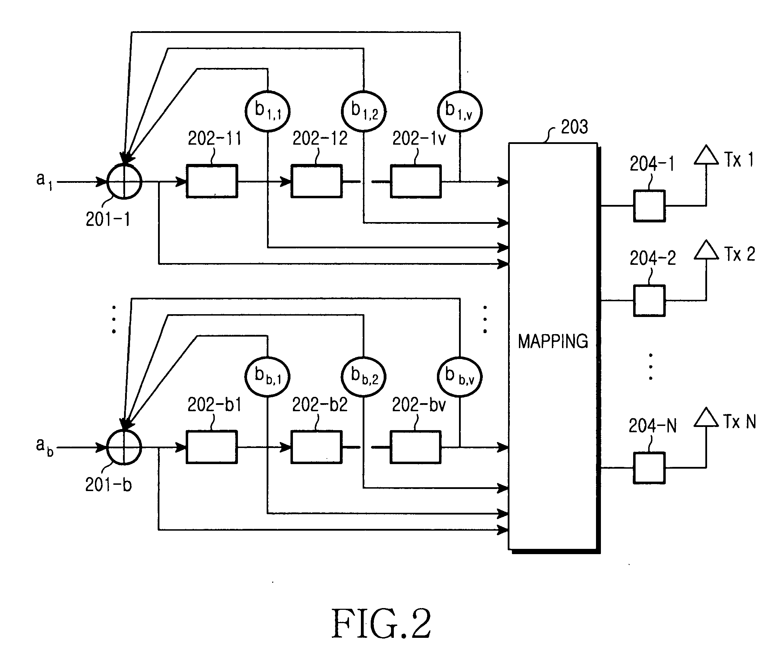

FIG 2 illustrates in detail a typical RSTTC encoder used as the internal encoder 13 in the general transmission system.

The internal encoder 13 of the general transmission system uses a typical RSTTC encoder. Referring to FIG 2, the typical RSTTC encoder includes adders 201-1 through 201-b for receiving the data bit a interleaved by the interleaver 12 in the form of parallel data bits $a_1$ through $a_b$ and adding sequential delays of previously input data bits to the received data bits $a_1$ through $a_b$, a predetermined number of delay elements 202-11 through 202-bv for sequentially delaying and outputting input data bits, a mapping distributor 203 for mapping and transmitting outputs of the adders 201-1 through 201-b and outputs of the delay elements 202-11 through 202-bv to multiple antennas, and modulators 204-1 through 204-N for modulating signals that are mapped to multiple antennas by the mapping distributor 203 for transmission through the multiple antennas. In particular, the outputs of the delay elements 202-11 'through 202-bv are controlled to be fed back to the adders 201-1 through 201-b so that they can be added to input data bits in the next time slot.

A detailed description will be made regarding an operation using the foregoing structure. For simplicity, a description will be made in terms of the input data bit $a_1$.

Once the data bit $a_1$ is inputted, the input data bit $a_1$ and sequential delays of the previously input data bits multiplied by coefficients from $b_{1,1}$ through $b_{1,v1}$ respectively are added up by the adder 201-1. The output of the adder 201-1 is transmitted to the mapping distributor 203 and a first delay element 202-11. The first delay element 201-11 delays the output of the adder 201-1, outputs a delayed output to the mapping distributor 203, and the immediately next following delay element, i.e., a second delay element 202-12, and feeds the delayed output multiplied by coefficient $b_{1,1}$ back to the adder 201-1. Output paths of the delay elements 202-12 through 202-1v are the same as that of the first delay element 202-11. In other words, each of the output paths of the delay elements 202-12 through 202-1v is formed of the mapping distributor 203, the adder 201-1, and an immediately next following delay element.

Upon receiving the output of the adder 201-1 and the outputs bits of the delay elements 202-11 through 202-1v, the mapping distributor 203 distributes input signals to N antennas. Signals output from the mapping distributor 203 are modulated by the modulators 204-1 through 204-N and then inputted to the N antennas.

Since the RSTTC encoder of FIG 2 can acquire a superior interleaving gain when used in a Serially Concatenated Space-Time Code (SCSTC) scheme, it is usually used as an internal encoder in a general transmission system. A Layered Space-Time Code (LSTC) encoder may also be used as an internal encoder in a general transmission system.

However, the LSTC encoder only acquires a low diversity gain without coding gains. Moreover, since the LSTC encoder has a higher spectral efficiency, its error correction performance is worse.

When the RSTTC encoder of FIG 2 is used as an internal encoder, its transmission rate is limited to b bits/s (in FIG 2). Furthermore, in typical RSTTC encoding as shown in FIG 2, since components are serially connected for each bit and transmission data is created through sequential delay elements, the design and application of RSTTC encoding becomes complicated. In other words, since each parallel signal is branched through a plurality of delay elements and then coded, the design and application of RSTTC encoding becomes complicated.

It is the object of the present invention to provide a generalized RSTTC encoder which can improve the diversity gain and coding gain in terms of transmission without increasing circuit complexity in a transmission system.

This object is solved by the subject matter of the independent claims.

Preferred embodiments are defined in the dependent claims.

According to an aspect of the present invention, there is provided a generalized RSTTC encoder which can improve the diversity gain and coding gain in terms of transmission without increasing circuit complexity in a transmission system by forming an internal encoder of a multi-antenna mobile telecommunication system using a Recursive Systematic Convolutional code (RSC) block having two output ends to make the internal encoder a systematic code.

It is another aspect of the present invention to provide a generalized RSTTC encoder having a ratio of input data to output data (n-1):n using a plurality of parallel RSC blocks each having two output ends.

Another aspect of the present invention is to provide a generalized RSTTC encoder which allows mapping to antennas using simple linear mapping and a large amount of data bits input to each RSC block.

Another aspect of the present invention is to provide a corresponding method for operating the generalized RSTTC encoder.

To achieve the above, a generalized Recursive Space-Time Trellis Code (RSTTC) encoder in a multi-antenna mobile telecommunication system using a Space-Time Trellis Code (STTC) is provided. The generalized RSTTC encoder includes a serial-to-parallel converter for receiving and parallel-converting a data bit (a), a second predetermined number (K) of Recursive Systematic Convolutional code (RSC) blocks for receiving data of a first predetermined number of bits ($n_k$-1 bits) among parallel-converted data bits (m bits) output from the serial-to-parallel converter and outputting the received data of the first predetermined number of bits and data resulting from processing of the received data of the first predetermined number of bits, and a mapping distributor for receiving data output from the second predetermined number of RSC blocks, mapping the data to multiple antennas, and transmitting the data to the multiple antennas.

The present invention will become more apparent from the following detailed description when taken in conjunction with the accompanying drawings in which:

FIG 1 is a schematic block diagram of a general transmission system; FIG 2 illustrates in detail a typical RSTTC encoder used as an internal encoder in a general transmission system;

FIG 3 illustrates a generalized RSTTC encoder according to an embodiment of the present invention;

FIG 4 illustrates in detail a RSC block included in a generalized RSTTC encoder according to an embodiment of the present invention;

FIGs. 5A and 5B illustrate a generalized RSTTC encoder having two antennas according to an embodiment of the present invention;

FIG 6 is a graph showing performance improvement when an input to a generalized RSTTC encoder is a minimum according to the present invention;

FIG 7 is a graph showing performance improvement when an input to a generalized RSTTC encoder is a maximum according to the present invention.

Preferred embodiments of the present invention will now be described in detail with reference to the annexed drawings. A detailed description of known functions and configurations incorporated herein has been omitted for conciseness in the following.

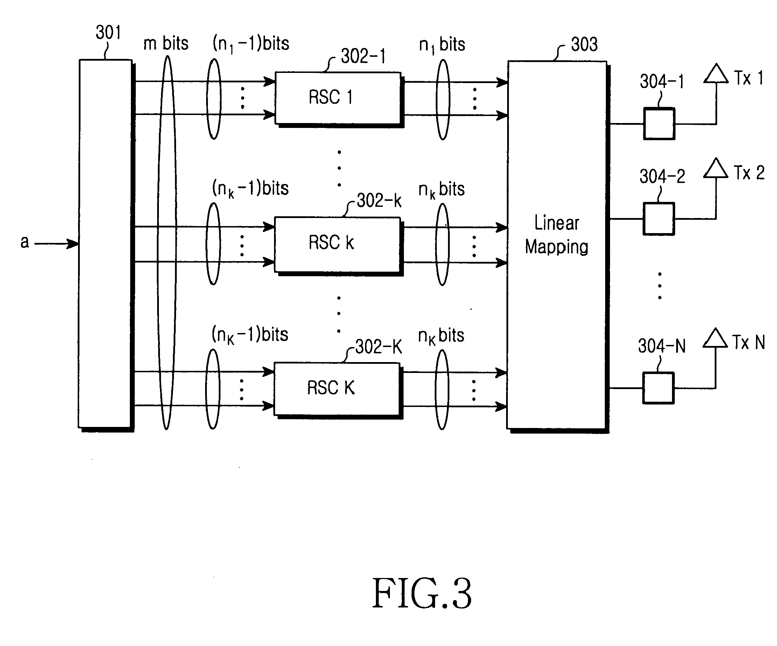

Referring to FIG 3, the generalized RSTTC encoder includes a serial-to-parallel (S/P) converter 301 for receiving a data bit a interleaved by an interleaver of a transmission system of FIG 1 and parallel-converting the received data bit a, a plurality of RSC blocks 302-1 through 302-K each for receiving data of a first predetermined number of bits ($n_k$-1 bits where k is an index for indicating a corresponding RSC block) among parallel-converted data of m bits output from the S/P converter 301, adding the received data of the first predetermined number ($n_k$-1) of bits and data that was previously created by delaying previously input data of the first predetermined number ($n_k$-1) of bits and was fed back, delaying the result of the addition, and outputting the result of the delaying and the received data of the first predetermined number ($n_k$-1) of bits, a linear mapping distributor 303 for mapping and transmitting outputs of the plurality of RSC blocks 302-1 through 302-K to multiple antennas, and modulators 304-1 through 304-N for modulating signals that are mapped to multiple antennas by the linear mapping distributor 303 for transmission through the multiple antennas.

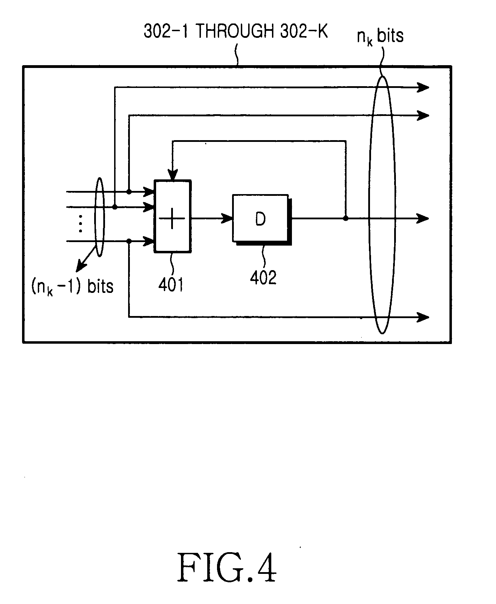

The plurality of RSC blocks 302-1 through 302-K will now be described in more detail with reference to FIG 4.

For simplicity, a description will be made of the RSC block 302-1. The RSC block 302-1 includes one adder 401 and one delay element 402. The adder 401 intactly outputs data of the first predetermined number ($n_k$-1) of bits input to the RSC block 302-1, adds the input data of the first predetermined number ($n_k$-1) of bits and data that was previously created by delaying previously input data of the first predetermined number ($n_k$-1) of bits in the delay element 402 and was fed back to the adder 401 from the delay element 402, and outputting the result of the addition to the delay element 402. Thus, final output data is composed of $n_k$ bits. Herein, the previously created data means data that is fed back to the adder 401 from the delay element 402.

The adder 401 adds the data of the predetermined number ($n_k$-1) of bits input to the RSC block 302-1 and the data fed back from the delay element 402. The delay element 402 delays and then outputs the output of the adder 401. At this time, the data fed back from the delay element 402 is not the data of the predetermined number ($n_k$-1) of bits input to the RSC block 302-1 among the final output data of $n_k$ bits, but is data that is previously created by delaying previously input data by 1 bit of the first predetermined number ($n_k$-1) of bits in the delay element 402. The previously created data with 1 bit delay is fed back to the adder 401 and is added by the adder 401 to the data of the predetermined number ($n_k$-1) of bits input to the RSC block 302-1.

When using the generalized RSTTC encoding according to an embodiment of the present invention as shown in FIG. 3, the following characteristics can be acquired.

The number of data bits input to each adder may be set less than m, the total size of input data. The number of branches such as RSC blocks may be set to a value K. Each of the branches uses a single delay element, and systematic code blocks that intactly output input data are selected. Based on such characteristics, a simple linear mapping distributor for output to antennas is used.

The characteristics satisfy Equation 1.

$$\sum_{k=1}^{K}(n_k - 1) = m, \quad \sum_{k=1}^{K} n_k = Nb \qquad \cdots\cdots\cdots (1),$$

where m represents the total number of input data bits, K represents the number of RSC blocks having two output ends in the generalized RSTTC encoder, $n_k$ represents the number of output data bits of a $k^{th}$ RSC block having two output ends, b is the modulation order, and N represents the number of transmission antennas.

In other words, based on Equation 1, it can be seen from FIG. 3 that the total number of data bits input to the generalized RSTTC encoder according to an embodiment of the present invention is m, the number of RSC blocks is K, the number of bits output from each of the RSC blocks is $n_k$, and the number of transmission antennas is N.

Thus, the total number of data bits input to the RSC blocks is equal to m and the total number of data bits output from the RSC blocks is equal to Nb, that is the total number of data bits transmitted through the antennas.

As a result, a combination of (Nb-m=K) and any $n_k$ can be made.

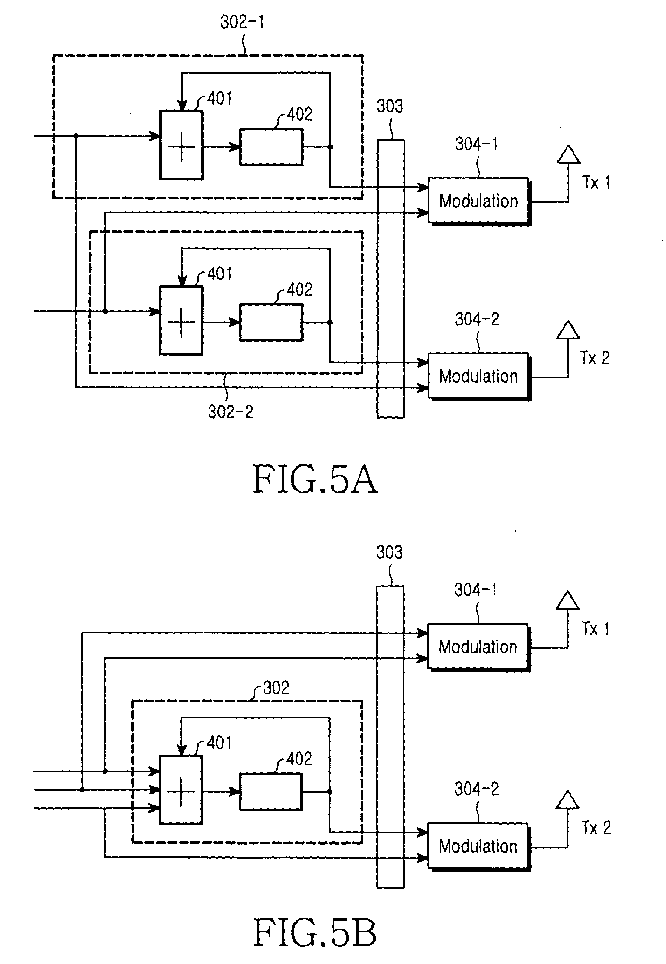

FIGs. 5A and 5B illustrate a generalized RSTTC encoder having two antennas. FIG 5A illustrates a portion for 2-bit/s/Hz 4PSK in the generalized RSTTC encoder having two antennas according to an embodiment of the present invention.

Referring to FIG 5A, the total number of input bits (m) is 2, the total number of output bits of RSC blocks 302-1 and 302-2 is 4, and the number of transmission antennas (N) is 2. Thus, the number of RSC blocks (K) is 2 as acquired by subtracting the total number of input bits (m), i.e., 2, from a result of multiplying the number of transmission antennas (N), i.e., 2 by the number of inputs to each of the transmission antennas (b), i.e., 2.

Hereinafter, a description will be made regarding an operation of the generalized RSTTC encoder having two antennas according to an embodiment of the present invention with reference to FIG 5A. Two input bits are input to the RSC block 302-1 and 302-2, respectively. Since the RSC block 302-1 and 302-2 operate in the same manner, a description will be made only on the RSC block 302-1.

Input data is branched into two parts: one is intactly output and the other is input to the adder 401. Herein, the intactly output data is referred to as a first output. The data input to the adder 401 is added to data output from the delay element 402 by the adder 401 and is then inputted to the delay element 402 to be delayed for a predetermined amount of time. The data output from the delay element 402, which is delayed by the predetermined amount of time, is branched into two parts: one is intactly output from the RSC block 302-1 and the other is fed back to the adder 401. Herein, the data output from the delay element 402 is referred to as a second output.

Four data bits output from the RSC blocks 302-1 and 302-2 are mapped to antennas by the linear mapping distributor 303 and are outputted. In FIG 5A, the first output of the RSC block 302-1 is mapped to the second antenna Tx 2 and the second output of the RSC block 302-1 is mapped to the first antenna Tx 1. In a similar manner, the first output of the RSC block 302-2 is mapped to the first antenna Tx 1 and the second output of the RSC block 302-2 is mapped to the second antenna Tx 2.

Such mapping to antennas is performed by the simple linear mapping distributor 303, and data that is output from the linear mapping distributor 303 for transmission through the antennas is modulated by the modulators 304-1 and 304-2 and then inputted to the antennas.

FIG 5B illustrates a portion for 3-bit/s/Hz 4PSK in the generalized RSTTC encoder having two antennas according to an embodiment of the present invention.

Referring to FIG. 5B, the total number of input bits (m) is 3, the total number of output bits ($n_k$) of a RSC block 302 is 4, and the number of transmission antennas (N) is 2. Thus, the number of RSC blocks (K) is 1 as acquired by subtracting the total number of input bits (m), i.e., 3, from a result of multiplying the number of transmission antennas (N), i.e., 2 by the number of inputs to each of the transmission antennas (b), i.e., 2.

Hereinafter, a description will be made regarding an operation of the generalized RSTTC encoder having two antennas according to an embodiment of the present invention with reference to FIG 5B. Three bits are inputted to the RSC block 302.

Input data is branched into two parts: one is intactly output and the other is input to the adder 401. Herein, the intactly output data is referred to as first, second, and third outputs. The adder 401 adds the input data and data fed back from the delay element 402. The result of the addition, acquired from the adder 401, is inputted to the delay element 402, delayed for a predetermined amount of time by the delay element 402, and is then outputted. The data output from the delay element 402 is branched into two parts: one is intactly output from the RSC block 302 and the other is fed back to the adder 401. Herein, the data output from the delay element 402 is referred to as the fourth output.

Four outputs from the RSC block 302 are mapped to antennas by the linear mapping distributor 303 and are outputted to the antennas. In FIG 5B, the first output and the second output of the RSC block 302 are mapped to the first antenna Tx 1 and the third output and the fourth output of the RSC block 302 are mapped to the second antenna Tx 2.

Such mapping to antennas is performed by the simple linear mapping distributor 303, and data output from the linear mapping distributor 303 for transmission through the antennas is modulated by the modulators 304-1 and 304-2 and then inputted to the antennas.

In the foregoing description, the generalized RSTTC encoder having two antennas is taken for example. However, the present invention is not limited to such a configuration and can be implemented in various forms such as 3 bit/s/Hz 4PSK, 4 bit/s/Hz 4PSK, or 5 bit/s/Hz 4PSK having three antennas. Such various forms will be obvious to those skilled in the art.

According to the present invention, various configurations satisfying Equation 1 can be made. Thus, a higher and more flexible data rate can be acquired without configuring a complicated circuit when compared to a conventional RSTTC scheme. In addition, when the same size of constellation and the same number of antennas are provided to an LSTC scheme and the generalized RSTTC encoder according to the present invention, extra diversity gain and coding gain can be acquired with only a loss of 1 bit and a little increase in complexity when compared to the LSTC scheme.

In addition, a flexible data rate varying from N to Nb-1 bit/s/Hz can be acquired and the diversity gain and coding gain can be increased without increasing the complexity of an RSTTC scheme when compared to schemes using LSTC or using conventional RSTTC as inner code.

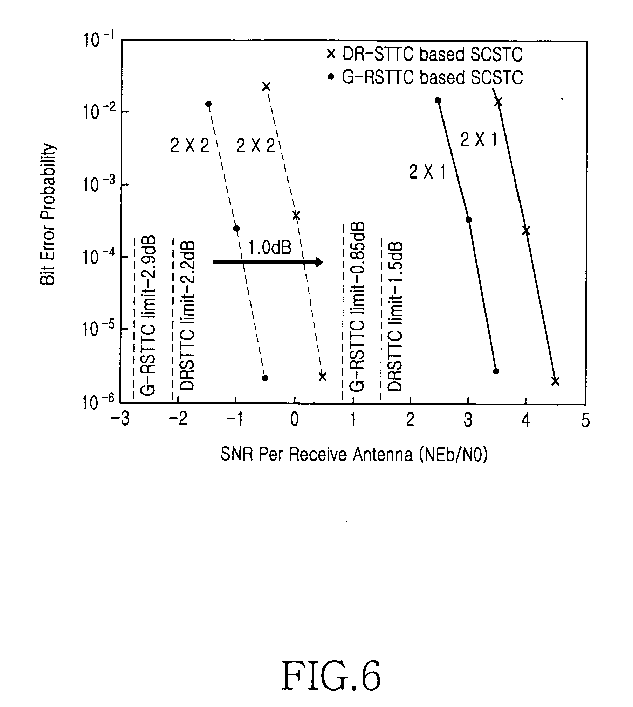

FIG 6 is a graph showing the performance improvement when the number of input bits to a generalized RSTTC encoder takes the minimum value according to the present invention.

FIG 6 shows comparison between the performance of a generalized RSTTC encoder according to the present invention and a conventional delay RSTTC (DR-STTC) encoder when the number of input bits to the generalized RSTTC encoder takes the minimum value. Herein, the input bit number to the generalized RSTTC encoder is minimumized when the total number of input bits (m) is equal to the number of antennas (N). As shown in FIG 6, a gain of 1dB is acquired when the generalized RSTTC encoder according to the present invention includes both two reception antennas and two transmission antennas (2x2) and one reception antenna and two transmission antennas (2x1).

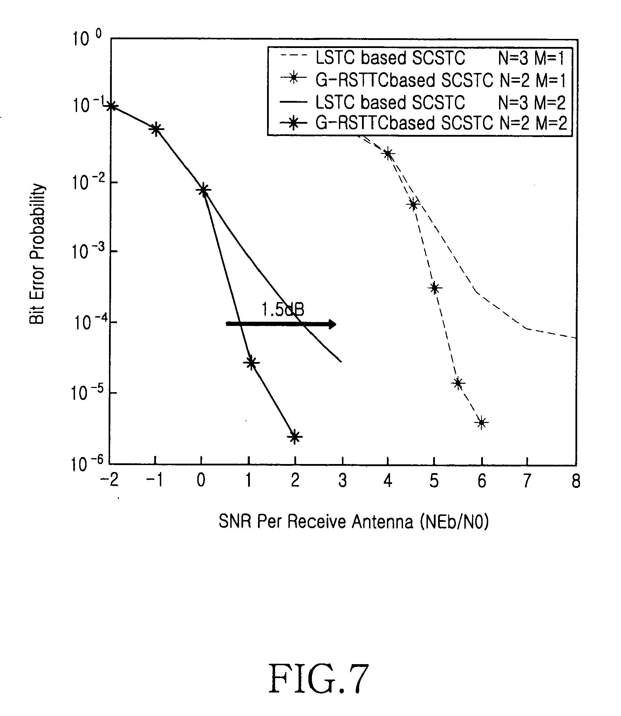

FIG 7 is a graph showing performance improvement when an input bit number to a generalized RSTTC encoder is maximumized according to the present invention.

FIG 7 shows the comparison between the performance of a generalized RSTTC encoder according to the present invention and a conventional LSTC scheme when an input bit number to the generalized RSTTC encoder is a maximumized. Herein, the input bit number to the generalized RSTTC encoder is maximumized when the total number of input bits (m) is equal to Nb (N represents the number of antennas and b represents the modulation order). Referring to FIG 7, both the LSTC scheme and the generalized RSTTC according to the present invention have rate of 3 bit/s/Hz. The LSTC scheme has three transmission antennas (N=3), and the generalized RSTTC encoder according to the present invention has two transmission antennas (N=2).

In such an environment, as shown in FIG 7, the transmission data rate for each antenna in the generalized RSTTC encoder according to the present invention is higher than the LSTC scheme and the signal-to-noise ratio (SNR) of the reception antenna in the generalized RSTTC encoder is equal to the LSTC scheme at a bit error probability up to $2 - 3 \times 10^{-2}$. The generalized RSTTC has a maximum gain of 1.5dB when compared to the LSTC scheme at a bit error probability less than $2 - 3 \times 10^{-2}$.

From above, according to the present invention, it is possible to improve the diversity gain and coding gain during transmission without increasing circuit complexity in a transmission system by forming an internal encoder using an RSC block having two ends to form a systematic code.

In addition, according to the present invention, flexibility can be given to the size of data input to each RSC block.

The present invention can be implemented as a computer program and stored in a storage media and read and executed by a computer. Examples of the storage media include Compact Disc Read-Only Memories (CD-ROMs), floppy disks, hard disks, and magneto-optical disks.

While the invention has been shown and described with reference to certain preferred embodiments thereof, it will be understood by those skilled in the art that various changes in form and details may be made therein without departing from the scope of the invention.

**Claims**

1. A generalized Recursive Space-Time Trellis Code, RSTTC, encoder in a multi-antenna mobile telecommunication system using a Space-Time Trellis Code, STTC, the generalized RSTTC encoder comprising:

   a serial-to-parallel converter for receiving and parallel-converting a data bit (a);
   a second predetermined number (K) of Recursive Systematic Convolutional code, RSC, blocks for receiving data of a first predetermined number of bits ($n_k$-1 bits) among parallel-converted data bits (m bits) output from the serial-to-parallel converter and outputting the received data of the first predetermined number of bits and data resulting from processing of the received data of the first predetermined number of bits; and
   a mapping distributor for receiving data output from the second predetermined number of RSC blocks, mapping the data to multiple antennas, and transmitting the data to the multiple antennas.

2. The generalized RSTTC encoder of claim 1, wherein each of the second predetermined number of RSC blocks comprises:

   a first branching unit for receiving the data of the first predetermined number of bits and branching the received data;
   an adder for adding the data of the first predetermined number of bits, which is branched by the first branching unit, and data branched by a second branching unit;

a delay element for receiving data resulting from the addition of the adder, delaying the received data for a predetermined amount of time, and outputting data resulting from processing of the input data of the first predetermined number of bits; and

the second branching unit for branching the data resulting from processing of the input data of the first predetermined number of bits, which is outputted from the delay element,

wherein the data of the first predetermined number of bits, which is branched by the first branching unit, and the data resulting from processing of the data of the first predetermined number of bits, which is branched by the second branching unit, form the output of each of the second predetermined number of RSC blocks.

3. The generalized RSTTC encoder of claim 1 or 2, being adapted for establishing a relationship among the number of antennas of the multi-antenna mobile telecommunication system, the first predetermined number, the second predetermined number, and the number of input data of the generalized RSTTC encoder according to

$$\sum_{k=1}^{K}(n_k - 1) = m, \quad \sum_{k=1}^{K} n_k = Nb,$$

where m represents the total number of parallel-converted input data of the generalized RSTTC encoder, K represents the number of RSC blocks, $n_k$ represents the number of output bits of a $k^{th}$ RSC block, $2^b$ represents the size of constellation, and N represents the number of transmission antennas of the multi-antenna mobile telecommunication system.

4. The generalized RSTTC encoder of claim 3, wherein the mapping distributor is a linear mapping distributor for linearly mapping the input data to the multiple antennas and transmitting the input data to the multiple antennas.

5. The generalized RSTTC encoder of claim 3, being further adapted for establishing said relationship for said first predetermined number being set less than m representing the total number of parallel-converted input data of the generalized RSTTC encoder.

6. The generalized RSTTC encoder of claim 3, wherein the second predetermined number satisfies

$$Nb - m = K,$$

where m represents the total number of parallel-converted input data of the generalized RSTTC encoder, K represents the number of RSC blocks, $2^b$ represents the size of constellation, and N represents the number of transmission antennas of the multi-antenna mobile telecommunication system.

7. A method for operating a generalized Recursive Space-Time Trellis Code, RSTTC, encoder according to one of claims 1 to 6.

FIG.1

FIG.2

EP 1 675 296 A2

FIG.3

EP 1 675 296 A2

302-1 THROUGH 302-K     $n_k$ bits

$(n_k-1)$ bits    401    402

# FIG.4

FIG.5A

FIG.5B

FIG.6

FIG.7